# EUROPEAN PATENT APPLICATION

(11) **EP 3 104 673 A1**
(43) Date of publication of application: **14.12.2016**
(21) Application number: 16171699.8
(22) Date of filing: 27.05.2016
(51) Int. Cl.: H05K 7/20, G05D 23/19, F24F 11/00

(54) **AIR CONDITIONING ASSEMBLY FOR SERVER ROOMS**

(30) Priority: 29.05.2015 IT UB20150900
(71) Applicant: Emerson Network Power S.R.L., 35028 Piove di Sacco (PD) (IT)
(72) Inventor: GOBBO, Maurizio, 35028 PIOVE DI SACCO PD (IT); POLO, Fabio, 30010 CAMPOLONGO MAGGIORE VE (IT)
(74) Representative: Modiano, Micaela Nadia

(57) **Abstract**

An air conditioning assembly (10) for server rooms, comprising a plurality of cooling and climate control units (11, 12, 13, 14) adapted to introduce cooling air into an environment to be climate controlled (15) in which are installed racks (16, 17, 18, 19) supporting electronic apparatuses to be kept at a controlled temperature, further comprising:
- a plurality of temperature sensors (21, 22, 23, 24, 25, 26) adapted to identify the temperature of corresponding regions of the environment to be climate controlled,
- an electronic control and management unit (27, 27a) preset to start one or more cooling and climate control units which are closer to the region in which a temperature reduction is required.

## Description

The present invention relates to an air conditioning assembly for server rooms.

Server rooms, and usually any site that contains numerous electronic apparatuses and racks for supporting a plurality of servers, electric and electronic instruments and the like, usually enclosed within adapted ventilated cabinets, require a continuous climate control adapted to prevent the heat originating from the computers and from the electronic instruments themselves from accumulating, thus determining temperatures that are so high as to damage the internal components of such electronic instruments and the like.

Nowadays, in order to overcome these drawbacks, floor climate control plants are usually installed in server rooms, and are increasingly widespread particularly in environments installed on a raised floor.

In fact the interspace between the ground and the raised floor can be easily fitted out not only for the distribution of cables for connecting and powering the racks and computers, but also as a plenum space, i.e. as an area for the passage of conditioned air, fed in by one or more cooling and climate control units, such plenum spaces conveying the air, either to the overlying environment or directly into the rack cabinets, by way of floor grilles.

Such cooling and climate control units for such climate control are usually constituted by a cabinet within which are arranged heat exchange means below which there are, usually arranged, in whole or in part, below the raised floor, one or more fans which are designed to aspirate air from the upper part of the cabinet so that it crosses the heat exchange means and is then pushed, treated, into the underfloor interspace.

Nowadays conditioning units placed in the same room can operate in a mutually correlated manner, sharing the principal operating parameters, only the necessary number thereof being activated to obtain the cooling required, and operating 'in cascade', i.e. switching on sequentially in a preset switch-on order.

Such management and control system of the conditioning units does not however ensure an efficient distribution of the cold.

It can happen in fact that the conditioning units that are called on to operate are the farthest from the thermal load, and these therefore are forced to run their fans at high speeds in order to ensure the cold air is thrust all the way to the areas farthest from them.

The same problem arises in general for conditioning machines of different types, which are preset to send air into the environment from above or frontally.

The aim of the present invention is to provide an air conditioning assembly for server rooms which is capable of overcoming the above mentioned drawbacks of conventional cooling and climate control systems.

Within this aim, an object of the invention is to provide a conditioning assembly that is capable of improving the diffusion of cooling air in the warmer regions of a server room while minimizing its consumption.

Another object of the invention is to provide a conditioning assembly that is easy to install, even in existing server rooms.

This aim and these and other objects which will become better apparent hereinafter are achieved by an air conditioning assembly for server rooms, comprising a plurality of cooling and climate control units adapted to introduce cooling air into an environment to be climate controlled in which are installed racks supporting electronic apparatuses to be kept at a controlled temperature, characterized in that it comprises:
- a plurality of temperature sensors adapted to identify the temperature of corresponding regions of the environment to be climate controlled,
- an electronic control and management unit preset to start one or more cooling and climate control units which are closer to the region in which a temperature reduction is required with respect to the other cooling and climate control units.

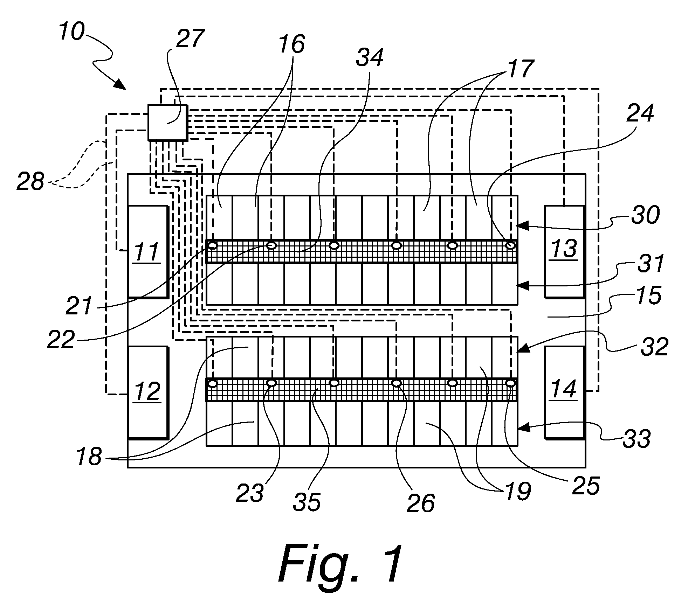

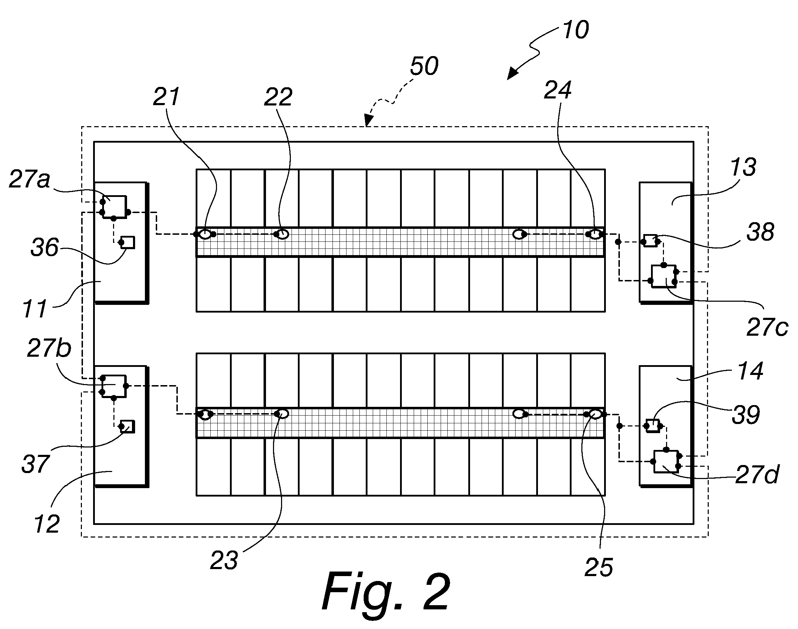

Further characteristics and advantages of the invention will become better apparent from the detailed description that follows of a preferred, but not exclusive, embodiment of the conditioning assembly for server rooms according to the invention, illustrated, by way of non-limiting example, in the accompanying drawings wherein Figure 1 is a schematic plan view of a conditioning assembly according to the invention, while Figure 2 is a variation of embodiment of the assembly of Figure 1.

With reference to the figures, an air conditioning assembly for server rooms is generally designated with the reference numeral 10.

The air conditioning assembly 10 comprises a plurality of cooling and climate control units, for example four units 11, 12, 13, 14 in the example in the schematic diagram in Figure 1, adapted to introduce cooling air into an environment to be climate controlled 15 in which racks are installed, for example 16, 17, 18, 19, supporting electronic apparatuses to be kept at a controlled temperature.

The peculiarity of the invention consists in that it comprises:
- a plurality of temperature sensors, for example 21, 22, 23, 24, 25, 26, which are arranged mutually spaced apart and are adapted to identify the temperature of corresponding regions of the environment to be climate controlled,
- an electronic control and management unit 27, interconnected by way of respective wiring 28 to the conditioning unit 11, 12, 13 and 14 and to the sensors 16, 17, 18 and 19, preset to start the cooling and climate control units that are closer to the region in which a temperature reduction is required with respect to the other cooling and climate control units.

For example, in the server room shown schematically in Figure 1, there are server-supporting racks arranged in rows 30, 31, 32 and 33 which in turn are side-by-side in pairs so as to define central corridors 34 and 35 for the cooling air to rise from below the floor, with the conditioning units 11, 12, 13 and 14 which are of the type adapted to push air within a raised floor used as a plenum space for conveying the cooling air.

If there are first racks 16 and 18 supporting operating devices and therefore to be cooled, and there are second racks 17 and 19 supporting switched-off devices or without any devices, the sensors 21, 22 and 23 positioned proximate to the first racks 16 and 18 will detect a higher temperature than the temperature detected by the sensors 24, 25 and 26 positioned proximate to the second racks 17 and 19; as a consequence the control unit 27, having evaluated the readings of the sensors, causes the switching-on of one or more of the conditioning units 11 and 12 most proximate to the first racks 16 and 18, and modulates its cooling and ventilation speed in order to reduce the energy consumption to the minimum.

In the present embodiment the electronic control unit 27 is shown schematically as external and separate from the conditioning units 11, 12, 13 and 14.

Each conditioning unit 11, 12, 13 and 14 usually comprises an electronic control unit 27a, 27b, 27c and 27d respectively, which manages all the devices of the same conditioning unit, and each conditioning unit 11, 12, 13 and 14 has its own sensors 36, 37, 38 and 39 which detect the temperatures of the server-supporting racks in the region adjacent to each conditioning unit.

In a variation of embodiment, shown schematically in Figure 2, the conditioning units 11, 12, 13 and 14 are mutually interconnected in a data exchange network 50, for example a LAN network.

In such embodiment of the invention, the electronic control unit is one of the electronic units 27a, 27b, 27c, 27d for controlling the conditioning units 11, 12, 13 and 14, for example the electronic unit 27a of a first conditioning unit 11.

The electronic unit 27a of the first conditioning unit 11 is preset to operate as the master unit, and the other electronic units 27b, 27c, 27d operate as slave units; the master electronic unit 27a receives the data detected by the sensors, both the sensors proximate to the racks 21, 22, 23, 24, 25, and the sensors incorporated in the conditioning units 36, 37, 38 and 39, and decides which conditioning units are to operate and which are to remain on standby.

The master electronic unit 27a can determine that the conditioning unit 11 that it controls remains in standby while it continues to manage the other interconnected conditioning units.

The innovation lies in the fact that the electronic control unit 27 or 27a does not activate the conditioning unit 11, 12, 13 and 14 by following a sequential identification number, as in the known art, but activates the conditioning units on the basis of the distribution of the thermal load in the environment to be conditioned, i.e. in the areas where the temperature detected determines a requirement for conditioning, the conditioning unit is active, while where there is no requirement for conditioning the conditioning units remain on standby.

The entire method of operation functions dynamically, maximizing the energy savings of the site.

The air conditioning assembly 10 according to the invention is particularly useful for more recent server rooms, which are oversized with respect to the servers present inside them, i.e. they are not completely filled with server-supporting racks, and they are built with a greater cubic volume than that needed at present in view of possible future additions of server-supporting racks; such a situation means that, as shown for the purposes of example in the figures, the server-supporting racks 16 and 18 are effectively full of active servers and therefore emitters of heat, while the side-by-side racks 17 and 19 have no servers and therefore cannot generate heat.

With thermal loads skewed thusly within the same server room 15, the present invention brings considerable advantages to the management of consumption and to the optimal use of each conditioning unit, with consequent decrease in the wear of those same conditioning units.

Thanks to such a conditioning assembly 10 according to the invention, the typical situation of conventional conditioning assemblies does not arise, in which one or more conditioning units far from the racks to be cooled can be activated, with consequent low yield of the assembly and high energy consumption in order to make the cooling air reach great distances from the conditioning unit that emits it.

The sensors 21, 22, 23, 24, 25 and 26 are positioned, for example, between two side-by-side rows of racks, for example between the rows 30 and 31 and the rows 32 and 33.

Advantageously, the sensors are positioned at the upper part of the racks.

It should be understood that the conditioning assembly 10 according to the invention can be implemented with conditioning units of the underfloor air type, as well as with air emitted upward, and also with frontal-emission conditioning machines, as well as with other conditioning units and machines for server rooms.

In practice it has been found that the invention fully achieves the intended aim and objects.

In particular, with the invention a conditioning assembly is provided that is capable of improving the diffusion of cooling air in the warmer regions of a server room while minimizing its consumption.

Moreover, with the invention a conditioning assembly is provided that is easy to install, even in existing server rooms.

The invention, thus conceived, is susceptible of numerous modifications and variations, all of which are within the scope of the appended claims. Moreover, all the details may be substituted by other, technically equivalent elements.

In practice the components and the materials employed, provided they are compatible with the specific use, and the contingent dimensions and shapes, may be any according to requirements and to the state of the art.

The content of Italian patent application no. 102015000019128 (UB2015A000900), the priority of which is claimed in the present application, is incorporated as a reference.

Where the technical features mentioned in any claim are followed by reference numerals and/or signs, those reference numerals and/or signs have been included for the sole purpose of increasing the intelligibility of the claims and accordingly, such reference numerals and/or signs do not have any limiting effect on the interpretation of each element identified by way of example by such reference numerals and/or signs.

## Claims

1. An air conditioning assembly (10) for server rooms, comprising a plurality of cooling and climate control units (11, 12, 13, 14) adapted to introduce cooling air into an environment to be climate controlled (15) in which are installed racks (16, 17, 18, 19) supporting electronic apparatuses to be kept at a controlled temperature, **characterized in that** it comprises:
- a plurality of temperature sensors (21, 22, 23, 24, 25, 26) adapted to identify the temperature of corresponding regions of the environment to be climate controlled,
- an electronic control and management unit (27, 27a) preset to start one or more cooling and climate control units which are closer to the region in which a temperature reduction is required with respect to the other cooling and climate control units.

2. The air conditioning assembly (10) for server rooms according to claim 1, **characterized in that** said sensors are positioned between two laterally adjacent rows (30, 31, 32, 33) of racks.

3. The air conditioning assembly (10) for server rooms according to one or more of the preceding claims, **characterized in that** said sensors are positioned at the upper part of said racks.

4. The air conditioning assembly (10) for server rooms according to one or more of the preceding claims, **characterized in that** each conditioning unit (11, 12, 13, 14) comprises an electronic control unit (27a, 27b, 27c, 27d) and has its own sensors (36, 37, 38, 39) which detect the temperatures of the server-supporting racks in the region adjacent to each said conditioning unit.

5. The air conditioning assembly (10) for server rooms according to claim 4, **characterized in that** the conditioning units (11, 12, 13, 14) are mutually interconnected in a data exchange network (50), and said electronic control unit is constituted by one (27a) of the electronic control units (27a, 27b, 27c, 27d) of the conditioning units (11, 12, 13, 14), set to operate as the master unit, the other electronic units (27b, 27c, 27d) operating as slave units.
